# EUROPEAN PATENT SPECIFICATION

(11) **EP 1 754 292 B1**
(45) Date of publication and mention of the grant of the patent: **08.10.2008**
(21) Application number: 04736612.5
(22) Date of filing: 10.06.2004
(51) Int. Cl.: H01S 5/0687, H04B 10/155, H01S 5/024

(54) **WAVELENGTH STABILIZED LASER MODULE**
WELLENLÄNGENSTABILISIERTES LASERMODUL
MODULE LASER STABILISÉ EN LONGUEUR D'ONDE

(43) Date of publication of application: 21.02.2007
(73) Proprietor: Finisar Corporation, Sunnyvale, CA 94089 (US)
(72) Inventor: ERIKSSON, Urban, S-112 37 Stockholm (SE); FRÖJDH, Krister, S-125 57 Älvsjö (SE); GOOBAR, Edgard, S-116 68 Stockholm (SE)
(74) Representative: Büchel, Kaminski & Partner
(86) International application number: PCT/SE2004/000902
(87) International publication number: WO 2005/122348

(56) References cited:
- EP-A- 1 164 367
- EP-A- 1 215 777
- EP-A- 1 324 443
- EP-A- 1 458 070
- EP-A1- 0 415 645
- EP-A1- 0 818 859
- GB-A- 2 360 628
- JP-A- 60 117 695
- US-A- 2002 075 910
- US-A1- 2002 126 386

## Description

### THE BACKGROUND OF THE INVENTION AND PRIOR ART

The present invention relates generally to the production of laser signals which are suitable for wavelength division multiplex optical transmission systems. More particularly the invention relates to a wavelength stabilized laser module according to the preamble of claim 1.

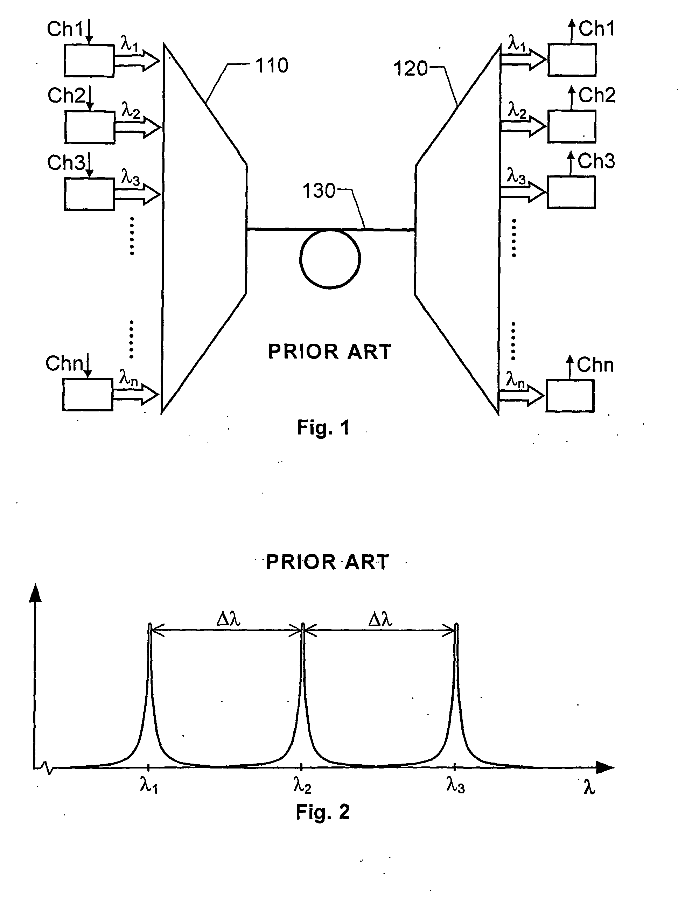

In an optical transmission system information is represented by light pulses which are transmitted over optical fibers. Furthermore, a single fiber may be used to transmit light of multiple wavelengths in order to obtain a high capacity and a high flexibility. Typically, semiconductor lasers are used to produce this light. In its most simple form, a wavelength division multiplexed (WDM) optical transmission system includes a number of transmission channels, where each channel transmits at a well-defined wavelength. Figure 1 schematically illustrates a WDM transmission system, where a number of different channels Ch1, Ch-2, ..., Chn are combined into a compound signal by means of an optical multiplexer (MUX) 110. The compound signal is then transmitted through an optical fiber 130, and at one or more end locations the individual channels Ch1, Ch2, ..., Chn are separated out by means of an optical demultiplexer (DEMUX) 120. Normally, the channels Ch1, Ch2, ..., Chn are placed at standardized wavelengths λ₁, λ₂, ..., λₙ with a particular wavelength separation Δλ between each channel. In a dense WDM (DWDM) system the channel separation is 100 GHz, which corresponds to a wavelength separation ΔX of approximately 0.8nm, see figure 2. The maximal allowed wavelength error is, of course considerably smaller, say 100 pm. This places very strict requirements on the accuracy and stability of the laser's wavelength. The relative accuracy needled is in the order of 0.005 percent or better. Typical semiconductor lasers incorporate a grating to obtain a stable single wavelength. Nevertheless, it is difficult to guarantee a particular wavelength over the lifetime of the component. Therefore it is important that mechanisms be provided, which monitor the laser wavelength and force it to its nominal value. These mechanisms normally include at least one feedback control loop that monitors and stabilizes the laser wavelength by locking it to a stable reference.

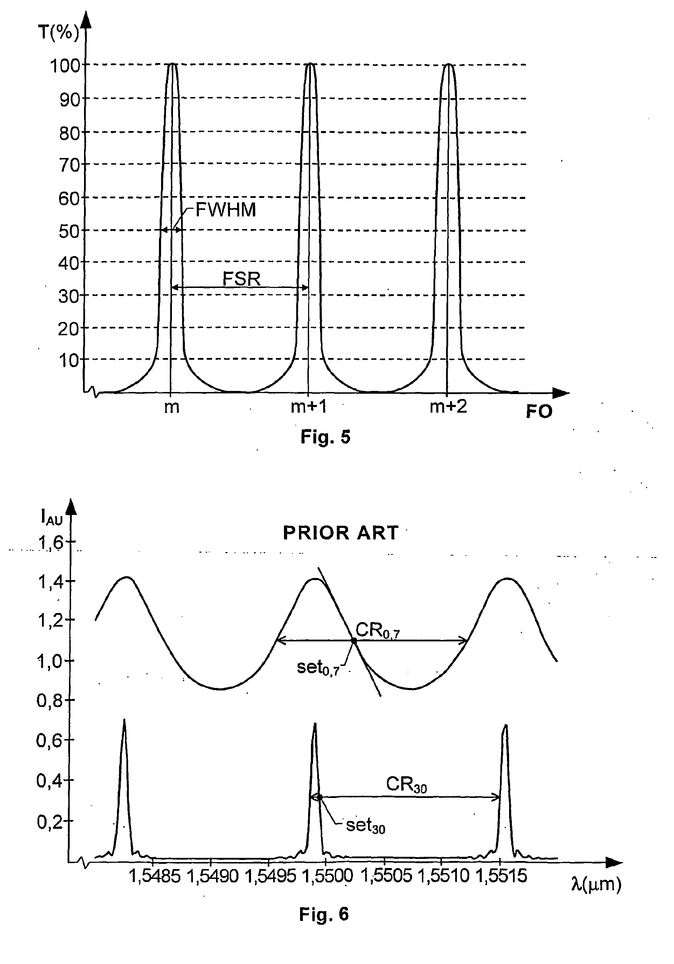

The prior art includes many different examples as how to accomplish a so-called wavelength locker for stabilizing a laser. One common element to obtain a wavelength reference is to use a Fabry-Perot etalon. This element has two parallel and partially reflecting surfaces. A common implementation is to use quarts (or a similar material) where a reflecting layer is deposited on one or both of the two surfaces. Light that is transmitted through the etalon has a periodic transmission dependence on the wavelength. The classical way to make use of a Fabry-Perot etalon is to direct a collimated, or nearly collimated, beam towards the etalon and detect the light which is transmitted through the etalon. By adjusting the reflectance of the mirrors it is possible to change the finesse of the etalon. The diagram in figure 5 illustrates the definition of the term finesse for a relatively high value. The horizontal axis shows fringe orders FO: m, m+1, m+2 etc. for monochromatic light passing through the etalon. The vertical axis shows the relative light transmission T in percent. For higher values, the finesse may be defined as the ratio of the separation of adjacent maxima, (the free spectral range, FSR), to the full width at half the maximum (FWHM), i.e. at T=50%. Thus, narrow and well-separated peaks are indicative of a high finesse, whereas a low finesse value is equivalent to much less well-defined peaks. In fact, more strictly, the finesse parameter is defined as the ratio π√R/(1-R), where R denotes the reflectance of the two parallel surfaces. This definition is applicable also to low finesse values.

In addition to the front facet, light may normally also be taken from the back facet of a semiconductor laser. This back-facet light is readily accessible, and may be used to measure and monitor the light produced by the laser. For instance, the back-facet light can be utilized to adjust the laser's drive current, such that the laser generates a constant output power. Moreover, the back-facet light may be used to accomplish a wavelength locking function.

The patent document EP 1 133 034 describes a wavelength stabilized laser module where light from the back facet is collimated by a lens. One part of the collimated beam is passed through an etalon-type filter to a first photoelectric converter, and another part of the collimated beam is transmitted directly to a second photoelectric converter. Hence, the first photoelectric converter measures light which has been transmitted through the etalon, whereas the second photoelectric converter samples unfiltered light from the laser so as to enable a power control. This solution presumes a parallel luminous flux, and therefore requires a lens or the like. However, such a lens arrangement is relatively expensive and uses considerable space. Moreover, the lens may cause reflections from the etalon and the photodetector to be reflected back and focused into the laser. This in turn, risks seriously degrading the laser's performance. According to the design of this document, the transmitted light shows the traditional Airy function dependence with the wavelength. It is therefore clear that a low-finesse etalon is required in order to obtain a simple locking to the function.

The U.S. patent 5,825,792 discloses a wavelength monitoring and control assembly for WDM optical transmission systems. Also here a lens is proposed to control the divergence of the light from the laser incident on a filter element in the form of a Fabry-Perot etalon. However, in this case the beam need not be completely collimated. The lens is therefore optional. The balance between two detectors is used to control the laser. Also here a relatively low-finesse etalon is needed for a proper function. Moreover, the detectors are placed symmetrical to the output light from the laser and both detectors receive light which has passed through the etalon. The laser wavelength is tuned by adjusting the angle of the etalon. Naturally, this renders the design very sensitive to any uncontrolled tilting of the etalon.

### SUMMARY OF THE INVENTION

The object of the present invention is therefore to provide a cost efficient, compact and robust wavelength stabilization for a laser module, which alleviates the above problems, and thus enables a reliable and efficient laser function over a broad range of filter angles.

A wavelength stabilized laser module according to the invention is defined in claim 1.

According to one aspect of the invention the object is achieved by the laser module as initially described, wherein the first sensor is arranged such that the first light signal directly illuminates a light-sensing surface of the sensor, i.e. without passing through the filter element.

An important advantage attained by means of this laser module is that a filter element may be used, which both has steep slopes (i.e. a feature associated with a high-finesse etalon) and a wide symmetric capture range (i.e. a feature normally associated with low-finesse etalons). The design is also relatively insensitive to variations in the relative angle between the filter element and the laser.

According to a preferred embodiment of this aspect of the invention, the second control loop includes a thermo-electric cooling unit which is associated with the laser. The thermo-electric cooling unit is adapted to receive the wavelength control signal and in response thereto adjust the temperature of the laser. This adjustment, in turn, results in a wavelength change.

According to another preferred embodiment of this aspect of the invention, the laser module includes a division unit, which is adapted to receive the first and the second electric signals. In response to these signals the division unit produces a composite control signal that is indicative of a ratio between the first electric signal and the second electric signal. The wavelength-monitoring module is adapted to receive the composite control signal, and in response thereto produce the wavelength control signal. By means of this design, the control current ratio is constant and the laser temperature will be tuned to the wavelength set value irrespective of the first electric signal, i.e. the power control current level.

According to yet another preferred embodiment of this aspect of the invention, the laser is adapted to produce the first and second light signals in the form of an uncollimated light flux. More preferably, the first light signal constitutes a first fraction of a divergent light beam from the laser while the second light signal constitutes a second fraction of this light beam. Thereby, a very compact and simple overall design is attained.

According to yet another preferred embodiment of this aspect of the invention, the second sensor and the filter element are arranged relative to the laser, such that a light ray from the laser passes perpendicularly through the filter element to the light-sensing surface of the second sensor. Namely, thereby, a light ray emitted radially from the laser may travel a shortest way through the filter element to the second sensor. This, in turn, results in comparatively good transmission efficiency from the filter element to the second sensor.

According to another preferred embodiment of this aspect of the invention, the filter element may have a non-zero filter tilt angle towards a laser central axis of the laser, and the light-sensing surface of the second sensor has a tilt angle towards the laser central axis, which is essentially equal to the filter tilt angle. This enhances the efficiency of the second sensor to some extent.

According to still another preferred embodiment of this aspect of the invention, the filter element has a filter tilt angle of seven degrees or less. Although a small filter tilt angle is generally preferable, the invention performs well over the entire range of angles between zero and seven degrees, and consequently allows a relatively large tolerance to any uncontrolled tilting of the filter element.

According to another preferred embodiment of this aspect of the invention, the laser is adapted to produce light, which has a wavelength in the interval 1530 nm to 1610 nm, e.g. in the C-band (1530-1565 nm) or in the L-band (1570-1610 nm). Moreover, the filter element is arranged, such that its light incident surface is located within 1600 µm from the laser. Hence, the invention provides a large degree of flexibility in terms of wavelength and geometry.

According to yet another preferred embodiment of this aspect of the invention, the light-sensing surface of the second sensor has an essentially rectangular outline with dimensions, which lie in the interval 50 µm to 400 µm, preferably above 200 µm. Namely, this sensor size strikes good balance between cost effectiveness/yield and angular sensitivity.

According to still another preferred embodiment of this aspect of the invention, a central axis of the second sensor is displaced at an offset distance with respect to the laser central axis, which is less than or equal to 350 µm. Thus, a relatively large offset of the second sensor can be accepted before the electric signal there from deteriorates to an unacceptably low quality.

According to another preferred embodiment of this aspect of the invention, the filter element has a thickness ranging from 300 µm to 1000 µm. Moreover, the filter element is arranged with the light exit surface within 1000 µm from the second sensor. Thus, the invention also allows relatively large geometry flexibility on the light-exit side.

To sum up, the invention provides compact and cost efficient laser wavelength stabilization over a broad tuning range. A design according to the proposed solution is also reliable, since there is no lens (or equivalent collimating element) between the laser and the filter element, and therefore the risk of back reflections from the sensor via the filter being focused into the laser is eliminated.

Further advantages, advantageous features and applications of the present invention will be apparent from the following description and the dependent claims.

### BRIEF DESCRIPTION OF THE DRAWINGS

The present invention is now to be explained more closely by means of preferred embodiments, which are disclosed as examples, and with reference to the attached drawings.
- Figure 1: shows a schematic block diagram over a per se known WDM optical transmission system,
- Figure 2: shows a diagram which illustrates the wavelength separation between the optical channels of the system in figure 1,
- Figures 3a-b: show diagrams illustrating the differences in angular sensitivity for a collimated light beam used in the prior art and an uncollimated beam used according to one embodiment of the invention,
- Figure 4: illustrates, by means of another diagram, the angular dependence of the locking wavelength for an uncollimated light beam and a collimated light beam respectively,
- Figure 5: defines the finesse parameter, which is used as a figure of the merit for the transmission bandwidth of a Fabry-Perot interferometer,
- Figure 6: show diagrams over per se known wavelength de- pendencies, with reference to which the finesse
- Figure 7: parameter is further elaborated upon, shows a diagram illustrating the capture range according to one embodiment of the invention,
- Figures 8a-b: show diagrams which elucidate the differences in the tuning ranges attainable by means of a collimated light beam used according to the prior art respective an uncollimated light beam used according to one embodiment of the invention,
- Figure 9: shows a block diagram over a wavelength stabi- lized laser module according to a first embodiment of the invention,
- Figure 10: shows a diagram illustrating how an appropriate set value is selected for the wavelength control signal according to one embodiment of the inven- tion,
- Figure 11: schematically illustrates the geometry of the wavelength stabilized laser module according to the invention,
- Figure 12: shows a block diagram over a wavelength stabi- lized laser module according to a second embo- diment of the invention,
- Figure 13: shows a diagram which illustrates the sensitivity of the displacement of the second sensor accor- ding to one embodiment of the invention,
- Figures 14-16: show diagrams which illustrate the sensitivity of the distance between the laser and the filter ele- ment according to one embodiment of the inven- tion,
- Figures 17-19: show diagrams which illustrate the sensitivity of the dimensions of the second sensor according to one embodiment of the invention,
- Figure 20: shows a diagram representing measurements of the light transmission prior to assembly respective after assembly of a filter element in an arrange- ment according to one embodiment of the inven- tion, and
- Figure 21: shows a diagram which illustrates the relationship between an actual laser wavelength and the laser's case temperature according to one embo- diment of the invention.

### DESCRIPTION OF PREFERRED EMBODIMENTS OF THE INVENTION

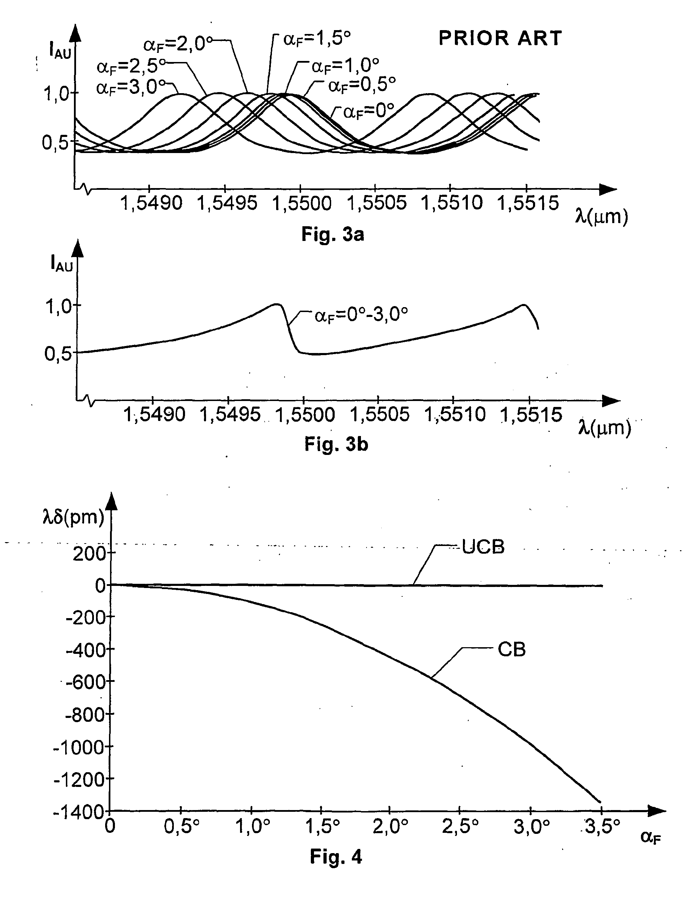

Figures 3a shows a diagram over the relationship between the light transmission for different tilt angles α_{F} of a particular narrow bandpass wavelength selective transmission filter element that has a Fabry-Perot structure, where a collimated light beam is used according to a known design. The horizontal axis of the diagram indicates the wavelength λ and the intensity I_{AU} of a sensor signal registered after the filter is represented along the vertical axis. As can be seen, the wavelength at which the transmission peaks occur here varies substantially depending on the filter tilt angle α_{F}. For example, a filter tilt angle α_{F} equal to 0° results in a first transmission peak around the wavelength λ=1,5499 µm, whereas for a filter angle α_{F} of 3,0°, this peak occurs around α=1,5492 µm. Thus, the light transmission has a relatively strong angular dependency.

Figures 3b shows another diagram over the relationship between the light transmission for different tilt angles α_{F} of the same filter element as in the figure 3a. Here, the filter element is arranged according to the invention, such that the filter constitutes an exclusive intermediary element between a laser and a light sensor. Hence, the light signal passes directly from the laser, through the filter element and further directly to the sensor. Preferably, the light from the laser represents an uncollimated flux. The filter element is tilted in angular steps of 0,5°, from 0° to 3,0°; however, there is no noticeable difference in the transmission profile. Instead, an accentuated transmission peak remained stable at approximately λ=1,5498 µm for all filter angles α_{F}. Consequently, the invention is insensitive for filter tilting, at least for relatively small tilt angles.

Figure 4 illustrates, by means of another diagram, the angular dependence of the locking wavelength for an uncollimated light beam UCB and a collimated light beam CB respectively. Here, the horizontal axis indicates the filter tilt angle α_{F}, and the vertical axis represents a center crossing wavelength shift δλ. For the collimated light beam CB a wavelength shift δλ of 50 pm occurs already at a filter tilt angle α_{F} of 0,6°. According to one embodiment of the invention, where an uncollimated light beam UCB is used, a tilt angle of α_{F}=3,5° merely results in a wavelength shift δλ of 3 pm. In fact, when UCB is used, a filter tilt angle as large as α_{F}=7,0° can be allowed before a wavelength shift δλ of 50 pm is reached. The corresponding value for the collimated light beam CB is 1350 pm (i.e. at α_{F}=7,0°).

Returning now to the figure 5, we find that the diagram shows an example of a Fabry-Perot type of filter element with a relatively high finesse, i.e. the ratio FSR/FWHM is rather large.

Figure 6 shows diagram where the horizontal axis indicates a wavelength λ and the vertical axis represents a light intensity I_{AU} detected after an etalon filter element of Fabry-Perot structure. A top-most diagram shows a light transmission graph for a conventional collimated light beam directed towards a filter with a finesse of 0,7, i.e. a relatively low value; and a bottom-most diagram shows a light transmission graph for a filter with a finesse of 30, i.e. a relatively high value. In both cases, a set point, set_{0,7} and set₃₀ respectively, around half the amplitude is used. The high finesse filter has a relatively steep slope around the set point set₃₀. This is preferable because thereby the wavelength λ can be adjusted very precisely without an extremely precise power measurement being required. However, a capture range CR₃₀, i.e. the interval within which the wavelength may be tuned to the set point set₃₀, becomes very asymmetric. This means that, in practice, only rather a small initial wavelength deviation can be handled, namely a deviation equal to the shortest fraction of the asymmetric capture range CR₃₀ from the set point set₃₀. As is apparent from the top-most diagram, the low finesse etalon has a much more symmetric capture range CR_{0,7}, and thus a wider effective tuning range. However here, the slope is less steep and therefore the wavelength precision less accurate.

In some applications it is more important to have a broad tuning range of the wavelength locker than to obtain a relatively high wavelength precision. One example is when the etalon thickness, and hence resonance wavelength, is not well controlled. In this case it is desirable with a characteristic were the absolute value of the derivative is reasonable high, while the regions close to a maximum can be avoided. Provided that a collimated light beam is used, this means that a low finesse filter element is required. However, for this type of filter there are large regions in the characteristics were the locking slope is very low. Moreover, the sign of the slope varies between the regions within the capture range.

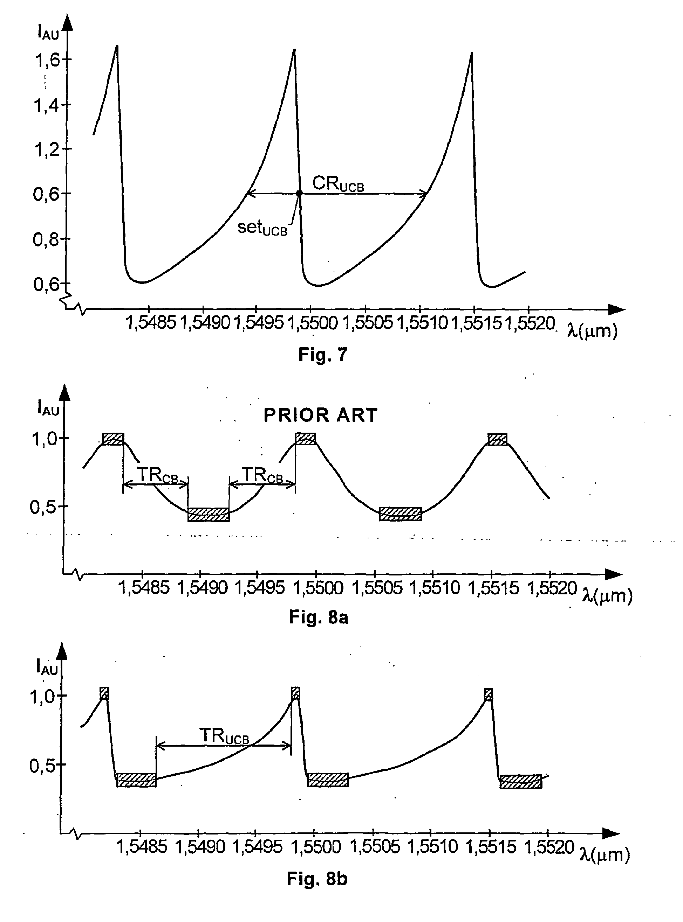

Figure 7 shows a diagram where again the horizontal axis indicates a wavelength λ and the vertical axis represents a light intensity I_{AU} detected after an etalon filter element of Fabry-Perot structure. Here, however, the design according to the invention is used, where an uncollimated light beam is directed towards the filter element. As can be seen from the graph, if a set point set_{UCB} is selected approximately around half the amplitude, the attainable capture range CR_{UCB} is relatively symmetric around this set point set_{UCB}. At the same time, the slope around the set point set_{UCB} is very steep, and consequently the wavelength λ may be adjusted very precisely without an exceedingly precise power measurement.

Figures 8a-b further elucidate the differences in the characteristics of the prior art strategy and the proposed design. The figure 8a shows a light transmission diagram where the horizontal axis indicates a wavelength λ and the vertical axis represents a light intensity I_{AU} of a collimated light beam, which is detected after an etalon filter element of Fabry-Perot structure with a relatively low finesse. Regions to be avoided around the maxima and minima are designated by means of broken-line boxes. Hence, a tuning range TR_{CB} is available between two of these neighboring boxes.

The figure 8b shows a light transmission diagram according to one embodiment of the invention where an uncollimated light beam is transmitted through an etalon filter element of Fabry-Perot structure. The horizontal axis indicates a wavelength λ and the vertical axis represents a light intensity I_{AU}. Again, regions to be avoided around the maxima and minima are designated by means of broken-line boxes. Here however, the available continuous tuning range TR_{UCB} between two neighboring boxes is nearly twice as broad as in the example of the figure 8a, i.e. TR_{UCB}≈2TR_{CB}.

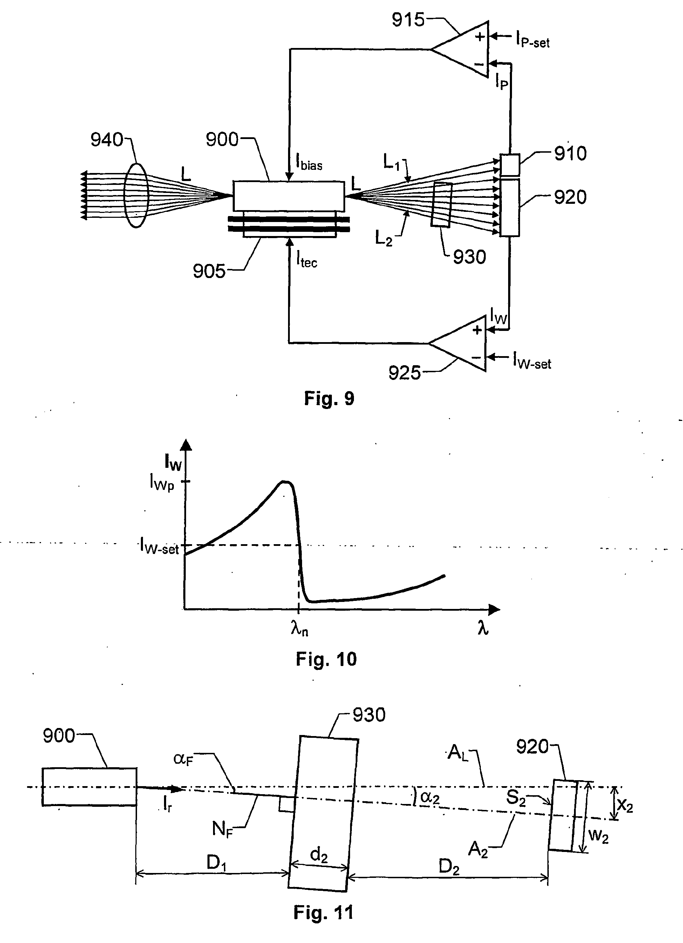

The general design of a laser module according to the invention will now be discussed with reference to figure 9. Here, a block diagram shows a first embodiment of a wavelength stabilized laser module. The laser module includes a semiconductor laser 900 and a thermo-electric cooling unit 905 associated therewith to control the wavelength of the light produced. However, according to the invention, alternative mechanisms are conceivable to adjust the wavelength, such as by means of an electrically tunable laser. In any case, the design also includes a first control loop, a second control loop and a narrow bandpass wavelength selective transmission filter element 930 of Fabry-Perot structure.

It is presumed that the spectrum characteristics of the light L produced by the laser 900 depends on both a power control signal I_{bias} and a temperature of the laser 900. The temperature is controlled by means of a wavelength control signal I_{tec} to the thermo-electric cooling unit 905. The light L primarily exits the laser 900 via a front facet and a lens arrangement 940 and continues, for example into an optical fiber. However, the light L is also tapped off via a back facet in the form of a first and a second light signal L₁ and L₂ respectively, and is directed towards a first and a second sensor 910 and 920. Preferably, the laser 900 is adapted to produce the first and second light signals L₁, and L₂ as an uncollimated light flux. For example, the first light signal L₁ constitutes a first fraction of a divergent light beam from the laser's 900 back facet, and the second light signal L₂ constitutes a second fraction of the divergent light beam from laser's 900 back facet.

The first control loop, in turn, includes the first sensor 910, which is adapted to produce a first electric signal I_{P} in response to the first light signal L₁ from the laser 900. A power monitoring module 915 in the loop receives the first electric signal I_{P} and a power set value I_{P-set} representing a desired power control signal I_{bias} to be delivered to the laser 900. The power monitoring module 915 produces the power control signal I_{bias} in response to the first electric signal I_{P} and the power set value I_{P-set}. For instance, the power monitoring module 915 may implement a comparator function, such that if the first electric signal I_{P} is smaller than the set value I_{P-set} the power control signal I_{bias} is increased, and vice versa.

Correspondingly, the second control loop includes the second sensor 920, which is adapted to produce a second electric signal I_{W} in response to the second light signal L₂ from the laser. Nevertheless, the second light signal L₂ has first passed through the filter element 930, which is arranged to constitute an exclusive intermediary element between the laser 900 and the second sensor 920. A wavelength-monitoring module 925 in the second control loop receives the second electric signal I_{W} and a wavelength set value I_{W-set}. Based on the second electric signal I_{W}, value relative to the wavelength set value I_{W-set}, the wavelength monitoring module 925 produces the wavelength control signal I_{tec}. Analogous to the above-described power-monitoring module 915, the wavelength-monitoring module 925 may represent a comparator function.

Of course, an appropriate wavelength set value I_{W-set} for the laser 900, which is adapted to transmit on a particular channel Chn (see the figure 1) is a current value I_{W} that corresponds to a desired wavelength λₙ for this channel. Figure 10 shows a diagram that illustrates the relationship between the second electric signal I_{W} and the wavelength λ of the laser light L. Preferably, the wavelength set value I_{W-set} also represents approximately half the peak value I_{Wp} of the second electric signal I_{W}.

Thus, returning now to figure 9, according to the invention the second light signal L₂ passes through the filter element 930 to a light-sensing surface of the second sensor 920, and the first light signal L₁ directly illuminates a light-sensing surface of the first sensor 910. Thereby, a robust wavelength stabilization of the laser 900 is accomplished, such that the light L has a well-defined wavelength over the entire life of the laser 900.

Figure 11 schematically illustrates the geometric relationships between the laser 900, the filter element 930 and the second sensor 920 of the wavelength stabilized laser module according to the invention. The filter element 930 is presumed to have a filter tilt angle α_{F} towards a laser central axis A_{L} of the laser 900 (i.e. the main direction along which light is emitted). In order to obtain an optimal performance, the filter tilt angle α_{F} should be as small as possible. Hence, the ideal filter tilt angle α_{F} is zero. Nevertheless, a filter tilt angle α_{F} which is smaller than or equal to 7 degrees is acceptable according to the invention.

According to a preferred embodiment of the invention, the second sensor 920 and the filter element 930 are arranged relative to the laser 900, such that a light ray Iᵣ from the laser 900 may pass perpendicularly N_{F} to the light incident and exit surfaces of the filter element 930 through the filter element 930 to the light-sensing surface S₂ of the second sensor 920. Namely, this orientation of the filter element 930 and the second sensor 920 renders it possible for a radial light ray Iᵣ from the laser 900 (which may be regarded as a point source) to pass a shortest distance through the filter element 930 and strike the light-sensing surface S₂. This, potentially, produces a strong electric signal (which is the second electric signal I_{W} in the figure 9).

The second sensor 920 has a light-sensing surface S₂, which may have a tilt angle α₂ towards the laser central axis A_{L}. According to another preferred embodiment of the invention, the tilt angle α₂ is essentially equal to the filter tilt angle α_{F}, such that the light-sensing surface S₂ is parallel to the light incident and exit surfaces of the filter element 930. Thereby, a light ray passing perpendicularly through the filter element 930 will also strike the light-sensing surface S₂ at a right angle, which vouches for an even stronger resulting electric signal.

Moreover, it is preferable if a central axis A₂ of the light-sensing surface S₂ is also essentially aligned with a line N_{F} from a light emitting point of the laser 900, which is perpendicular to the light incident and exit surfaces of the filter element 930. Thereby, the light ray Iᵣ will strike the center of the light-sensing surface S₂, and thus further improve the quality of the second electric signal I_{W}.

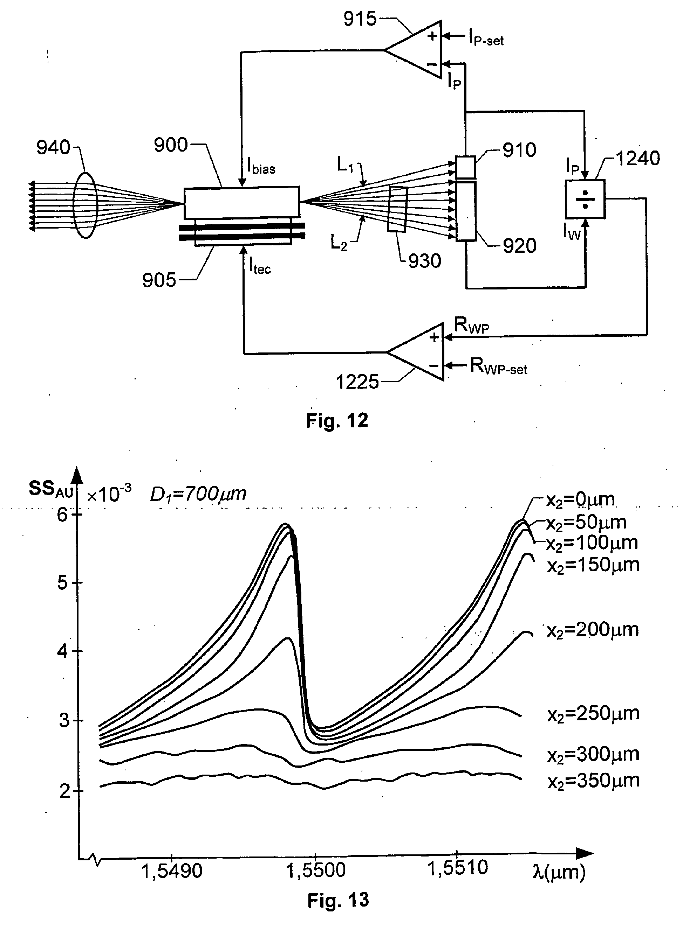

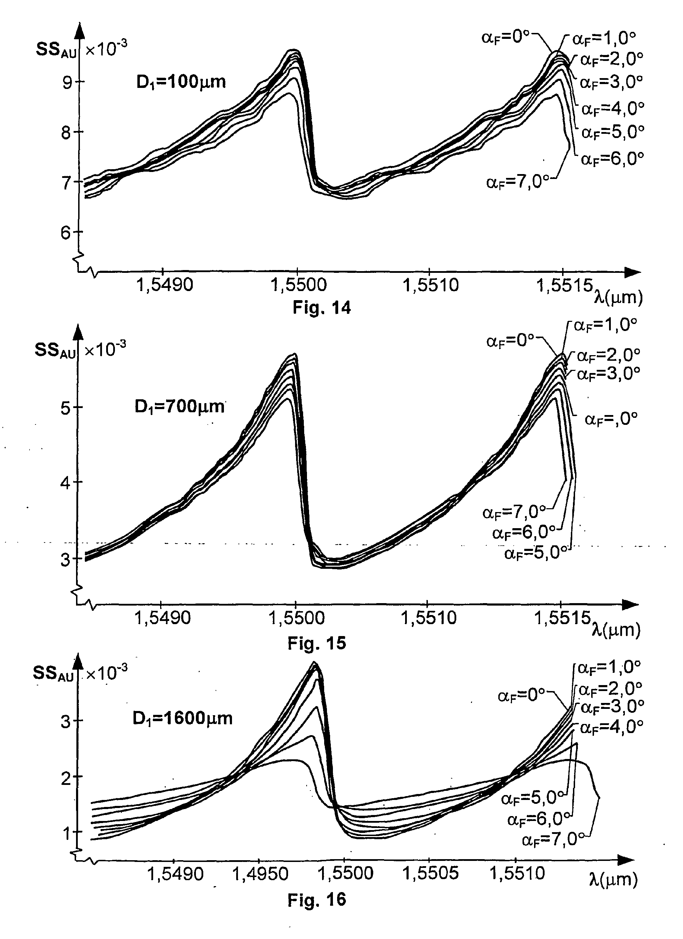

Measurements and simulations (see figures 14, 15 and 16) have confirmed that the filter element 930 should be arranged, such that a first distance D₁ between the laser 900 and the light incident surface of the filter element 930 is less than, or equal to, 1600 µm. Furthermore, other measurements and simulations (see figure 13) have shown that the central axis A₂ of the second sensor 920 should not be displaced, i.e. offset, by more than a distance X₂ equal to 350 µm with respect to the laser central axis A_{L}. Of course, the longest acceptable offset distance x₂ depends on the dimensions of the second sensor's 920 light-sensing surface S₂, such that a larger surface S₂, tolerates a longer offset distance x₂, and vice versa.

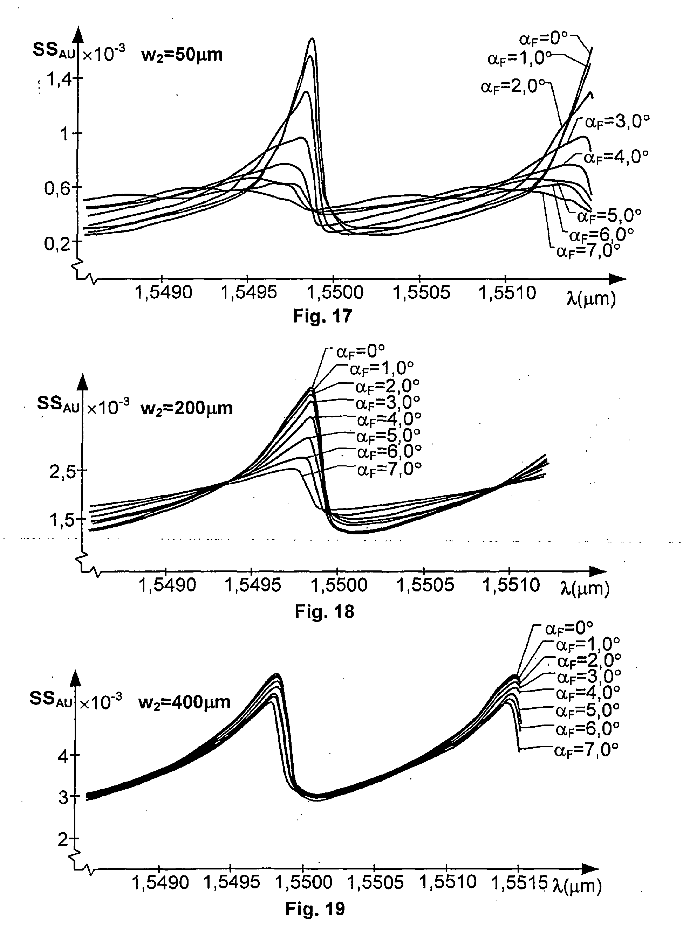

Generally, a large monitor size (i.e. a light-sensing surface S₂, with a large area) is preferable because this enables a strong resulting electric signal. A large monitor is also less sensitive to angular mismatches than a smaller ditto. However, large monitors are expensive, i.a. due to a lower yield. Additionally, an excessive light-sensing surface decreases the relative amplitude of the registered characteristic. Therefore, the monitor size is a parameter which must be optimized. According to measurements and simulations (see figures 17, 18 and 19), it is advantageous if the second sensor's 920 light sensing surface S₂ has an outline with dimensions in the interval 50 µm to 400 µm. Moreover, the surface should preferably be essentially rectangular and have a width w₂, which is approximately two times the height, say 400 µm wide and 200 µm high. (The width w₂ is here measured along the direction of any offset distance x₂ with respect to the laser central axis A_{L}). A sensor of these dimensions is namely relatively unproblematic to fabricate. Furthermore, a sensor of this size has characteristics that are favorable with respect to angular dependence and relative amplitude.

A distance D₂ between the light exit surface of the filter element 930 and the second sensor 920 is less critical. However, the invention has proven to be efficient up to a distance D₂ of 1000 µm. Likewise, a thickness d of the filter element 930 may be selected relatively freely, say in the interval 300 µm to 1000 µm.

The dimensions and measures discussed above with reference to the figure 11 presume that the semiconductor laser 900 produces light, which has a wavelength in the interval 1,5480 µm to 1,5525 µm. Naturally, if light is used, which has different spectral properties, this affects the dimensions and measures, so that a shorter wavelength generally requires a reduction of the geometry, and vice versa. In any case, the invention is at least applicable over the entire C- and L-bands, i.e. 1530 nm to 1565 nm and 1570 to 1610 nm respectively.

Figure 12 shows a block diagram over a wavelength stabilized laser module according to a second embodiment of the invention. The units and components whose reference signs occur also in the figure 9 designate the same units as discussed above with reference to this figure. Thus, the only difference between this embodiment of the invention and the first embodiment is that the second control loop includes a division unit 1240 and an alternative wavelength-monitoring module 1225.

The division unit 1240 receives the first electric signal I_{P} and the second electric signal I_{W}. In response to these signals, the unit 1240 produces a composite control signal R_{WP}, which is indicative of a ratio between the first electric signal I_{P} and the second electric signal I_{W}, i.e. R_{WP},=c·I_{P}/I_{W}, where c is a scale factor, say c=1. The wavelength-monitoring module 1225 receives the composite control signal R_{WP} and a composite wavelength set value I_{W-set}. In response to these signals, the wavelength-monitoring module 1225 produces the wavelength control signal I_{tec}. An advantage attained by means of this design is that the laser's 900 temperature will be controlled towards a value given by the composite wavelength set value I_{W-set} irrespective of the first electric signal's I_{P} level.

Returning briefly now to the figure 13, a diagram here illustrates the sensitivity of the displacement of the second sensor 920 according to one embodiment of the invention. The horizontal axis indicates the wavelength λ of the light from the laser 900, and the vertical axis shows an electric signal SS_{AU} produced by the second sensor 920. The distance D₁ between the laser 900 and the filter element 930 is 700 µm. As can be seen, offset distances x₂ of 250 µm or less result in clearly distinguishable characteristics. However, the design is operable at least up to offset distances x₂=350 µm for larger distances D₁.

Returning also to the figures 14-16, we see that the invention is relatively insensitive to filter tilt angles α_{F} up to seven degrees for distances D₁ between the laser 900 and the filter element 930 up to 1600 µm. Each of the diagrams in the figures 14-16 indicate the wavelength λ along the horizontal axis and show an amplitude SS_{AU} of the second electric signal I_{W} produced by the second sensor 920 along the vertical axis. In the figure 14 the distance D₁ between the laser 900 and the filter element 930 is 100 µm, and in the figures 15 and 16 this distance is 700 µm and 1600 µm respectively.

Similarly, by studying the figures 17-19 we find that the second electric signal I_{W} produced by the second sensor 920 has a clearly distinguishable characteristics for widths w₂ of the second sensor's 920 light-sensing surface S₂ in the interval 50 µm to 400 µm. Each of the diagrams also here indicate the wavelength λ along the horizontal axis and show amplitude SS_{AU} of the electric signal I_{W} along the vertical axis. In the figure 17 the width w₂ is 50 µm, and in the figures 18 and 19, this measure is 200 µm and 400 µm respectively.

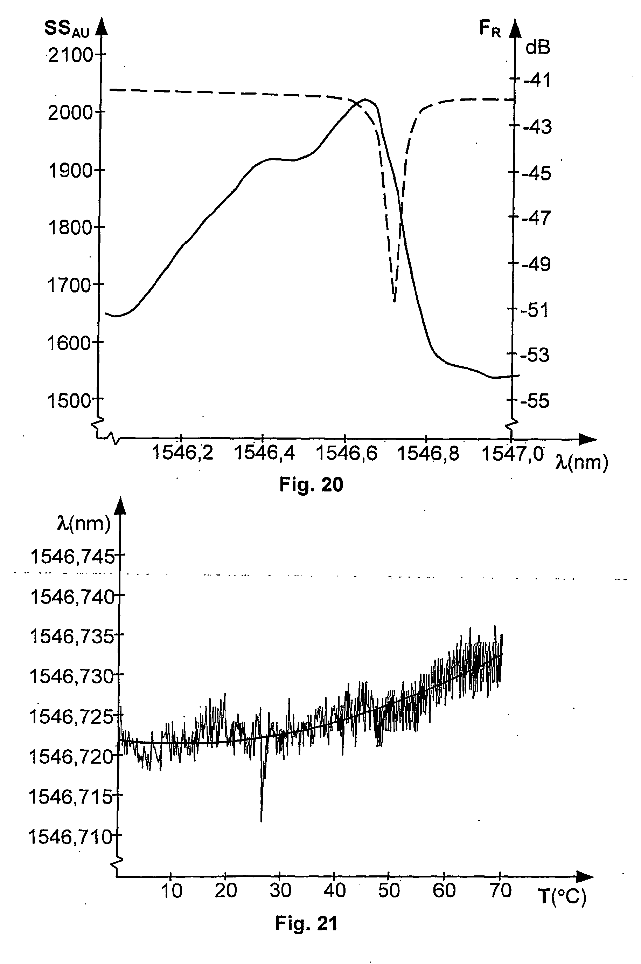

Figure 20 shows a diagram, where measurements of the filter element's 930 light transmission have been registered prior to assembly as well as after assembly in an arrangement according to one embodiment of the invention. The horizontal axis indicates a wavelength λ, a left-most vertical axis shows an amplitude SS_{AU} of the second electric signal I_{W} produced by the second sensor 920 and a right-most vertical axis shows a filter reflectivity F_{R} in dB (which represents an inverted measure of the transmission through the filter element 930).

A dashed graph represents a relationship between the filter reflectivity F_{R} and the wavelength λ for the filter element 930 prior to the assembly. A solid graph represents a relationship between the second electric signal I_{W} and the wavelength λ, i.e. when the filter element has been arranged according to one embodiment of the invention. Clearly, the solid graph shows a transmission peak around the wavelength λ=1546,6 nm. It is also apparent from the diagram that the unassembled filter element 930 has a transmission peak (i.e. a reflectance dip) approximately at this wavelength λ. Consequently, the arrangement is well tuned.

Finally, figure 21 shows a diagram, which illustrates the relationship between an actual laser wavelength λ and the laser's case temperature T according to one embodiment of the invention. Here, the horizontal axis indicates the temperature T, and the vertical axis shows the wavelength λ. The wavelength λ is plotted for each individual temperature value T as a thin solid graph, and an average temperature T is drawn as a bold solid graph. The latter illustrates the general relationship between the laser temperature T and the wavelength λ of the light produced by the laser. Apparently, the wavelength λ increases with an increasing temperature T.

The term "comprises/comprising" when used in this specification is taken to specify the presence of stated features, integers, steps or components. However, the term does not preclude the presence or addition of one or more additional features, integers, steps or components or groups thereof.

The invention is not restricted to the described embodiments in the figures, but may be varied freely within the scope of the claims.

## Claims

1. A wavelength stabilized laser module comprising:
a semiconductor laser (900) adapted to produce a light signal (L);
a first control loop including a first sensor (910) adapted to produce a first electric signal (Ip) in response to a first light signal (L₁) from the laser (900); and a power monitoring module (915) adapted to receive the first electric signal (I_{P}), and in response thereto produce a power control signal (I_{bias}) to the laser (900);
a second control loop including a second sensor (920) adapted to produce a second electric signal (I_{W}) in response to a second light signal (L₂) from the laser; and a wavelength monitoring module (925, 1225) adapted to, based on the second electric signal (I_{W}), produce a wavelength control signal (I_{tec}) to a wavelength adjustment interface of the laser (900), the wavelength control signal (I_{tec}) and the power control signal (I_{bias}) both influencing the spectrum characteristics of the light signal (L);
a narrow bandpass wavelength selective transmission filter element (930) of Fabry-Perot structure as a wavelength reference for the laser (900) arranged to constitute an exclusive intermediary element between the laser (900) and the second sensor (920),such that the second light signal (L₂) passes through the filter element (930) to a light-sensing surface (S₂) of the second sensor (920),
wherein the first sensor (910) is arranged such that the first light signal (L₁) directly illuminates a light-sensing surface of the first sensor (910) without passing through the filter element (930);
**characterized by**
a division unit (1240) adopted to receive the first electrical signal (Ip), receive the second electrical signal (I_{W}), and in response thereto produce a composite control signal (R_{WP}) indicative of a ratio between the first electrical signal (Ip) and the second electrical signal (I_{W}); the wavelength monitoring module (1225) is adapted to receive the composite control signal (R_{WP}), and in response thereto produce the wavelength control signal (I_{tec}) such that the laser (900) temperature will be controlled towards a value given by the composite wavelength set value (I_{W-set}) irrespective of the level of the first electrical signal (I_{P}).

2. A wavelength stabilized laser module according to claim 1,
**characterized in that**
the second control loop includes a thermo-electric cooling unit (905) associated with the laser (900), and the thermo-electric cooling unit (905) is adapted to receive the wavelength control signal (I_{tec}) and in response thereto adjust the temperature of the laser (900).

3. A wavelength stabilized laser module according to anyone of the claims 1 or 2,
**characterized in that**
the first light signal (L₁) and the second light signal (L₂) are tapped off via a back facet of the semiconductor laser (900).

4. A wavelength stabilized laser module according to anyone of the preceding claims,
**characterised in that**
the laser (900) is adapted to produce the first and second light signals (L₁, L₂) in the form of an uncollimated light flux.

5. A wavelength stabilized laser module according to claim 4,
**characterized on that**
the first light signal (L₁) constitutes a first fraction of a divergent light beam from the laser (900), and the second light signal (L₂) constitutes a second fraction of the divergent light beam from the laser (900).

6. A wavelength stabilized laser module according to anyone of the preceding claims,
**characterized in that**
the second sensor (920) and the filter element (930) are arranged relative to the laser (900) such that a light ray (Iᵣ) from the laser (900) passes perpendicularly (N_{F}) to the light incident and exit surfaces of the filter element (930) through the filter element (930) to the light-sensing surface (82) of the second sensor (920).

7. A wavelength stabilized laser module according to anyone of the preceding claims,
**characterized in that**
the filter element (930) has a filter tilt angle (α_{F}) towards a laser central axis (A_{L} of the laser (900); and
the light-sensing surface (S₂) of the second sensor (920) has a tilt angle (α₂) towards the laser central axis (A_{L} which is essentially equal to the filter tilt angle (α_{F}).

8. A wavelength stabilized laser module according to anyone of the preceding claims,
**characterized in that**
the filter element (930) has a filter tilt angle (α_{F}) smaller than or equal to 7 degrees.

9. A wavelength stabilized laser module according to anyone of the claims 6 to 8,
**characterized in that**
the semiconductor laser (900) is adapted to produce light having a wavelength in the interval 1530 nm to 1610 nm; and
the filter element (930) is arranged with the light incident surface at a first distance (D₁) from the laser (900) which is less than or equal to 1600 µm.

10. A wavelength stabilized laser module according to anyone of the claims 6 to 9,
**characterized in that**
the light-sensing surface (S₂) of the second sensor (920) has an essentially rectangular outline with dimensions (W₂) in the interval 50 µm to 400 µm.

11. A wavelength stabilized laser module according to anyone of the claims 6 to 10,
**characterized in that**
a central axis (A₂) of the second sensor (920) is displaced at an offset distance (X₂) with respect to the laser central axis (A_{L}), and the offset distance (X₂) is smaller than or equal to 350 µm.

12. A wavelength stabilized laser module according to anyone of the claims 6 to 11,
**characterized in that**
the filter element (930) has a thickness (d) in the interval 300 µm to 1000 µm; and is arranged with the light exit surface at a second distance (D₂) within 1000 µm from the second sensor (920).

## Patentansprüche

1. Wellenlängenstabilisiertes Lasermodul mit
einem für die Erzeugung eines Lichtsignals (L) geeigneten Halbleiterlaser (900);
einer ersten Steuerschleife mit einem ersten Sensor (910), der dafür geeignet ist, als Reaktion auf ein erstes Lichtsignal (L₁) vom Laser (900) ein erstes elektrisches Signal (I_{P}) zu erzeugen; und einem Leistungsüberwachungsmodul (915), das dafür geeignet ist, das erste elektrische Signal (I_{P}) zu empfangen und als Reaktion darauf ein Leistungssteuersignal (I_{bias}) zum Laser (900) zu erzeugen;
einer zweiten Steuerschleife mit einem zweiten Sensor (920), der dafür geeignet ist, als Reaktion auf ein zweites Lichtsignal (L₂) vom Laser ein zweites elektrisches Signal (I_{W}) zu erzeugen; und einem Wellenlängenüberwachungsmodul (925, 1225), das dafür geeignet ist, auf der Grundlage des zweiten elektrischen Signals (I_{W}) ein Wellenlängensteuersignal (I_{tec}) zu einer Wellenlängenjustierschnittstelle des Lasers (900) zu erzeugen, wobei das Wellenlängensteuersignal (I_{tec}) und das Leistungssteuersignal (I_{bias}) beide die Spektralkennlinie des Lichtsignals (L) beeinflussen;
einem wellenlängenselektiven Durchlassfilterelement (930) der Fabry-Perot-Struktur mit engem Passband als Wellenlängen-Bezugsorgan für den Laser (900), das so angeordnet ist, dass es ein exklusives Zwischenelement zwischen dem Laser (900) und dem zweiten Sensor (920) in dem Sinne darstellt, dass das zweite Lichtsignal (L₂) durch das Filterelement (930) zu einer lichtempfindlichen Oberfläche (S₂) des zweiten Sensors (920) hindurchgeht,
worin der erste Sensor (910) so angeordnet ist, dass das erste Lichtsignal (L₁) eine lichtempfindliche Oberfläche des ersten Sensors (910) direkt beleuchtet, ohne durch das Filterelement (930) hindurchzugehen;
**gekennzeichnet durch**
eine Teilungseinheit (1240), dazu geeignet, das erste elektrische Signal (I_{P}) zu empfangen, das zweite elektrische Signal (I_{W}) zu empfangen und als Reaktion darauf ein zusammengesetztes Steuersignal (R_{WP}) zu erzeugen, das ein Ausdruck für das Verhältnis zwischen dem ersten elektrischen Signal (I_{P}) und dem zweiten elektrischen Signal (I_{W}) ist; das Wellenlängenüberwachungsmodul (1225) ist dafür geeignet, das zusammengesetzte Steuersignal (R_{WP}) zu empfangen und als Reaktion darauf das Wellenlängensteuersignal (I_{tec}) so zu erzeugen, dass die Temperatur des Lasers (900) zu einem Wert hin gesteuert wird, der ohne Rücksicht auf den Pegel des ersten elektrischen Signals (I_{P}) **durch** den festgelegten Wert (I_{W-set}) der zusammengesetzten Wellenlänge gegeben ist.

2. Wellenlängenstabilisiertes Lasermodul nach Anspruch 1,
**dadurch gekennzeichnet, dass**
die zweite Steuerschleife eine mit dem Laser (900) verbundene thermoelektrische Kühleinheit (905) enthält, die dafür geeignet ist, das Wellenlängensteuersignal (I_{tec}) zu empfangen und als Reaktion darauf die Temperatur des Lasers (900) anzupassen.

3. Wellenlängenstabilisiertes Lasermodul nach einem der Ansprüche 1 oder 2,
**dadurch gekennzeichnet, dass**
das erste Lichtsignal (L₁) und das zweite Lichtsignal (L₂) über eine Rückseite des Halbleiterlasers (900) abgezapft werden.

4. Wellenlängenstabilisiertes Lasermodul nach einem der vorangehenden Ansprüche,
**dadurch gekennzeichnet, dass**
der Laser (900) dafür geeignet ist, das erste und das zweite Lichtsignal (L₁, L₂) in Gestalt eines nicht kollimierten Lichtflusses zu erzeugen.

5. Wellenlängenstabilisiertes Lasermodul nach Anspruch 4,
**dadurch gekennzeichnet, dass**
das erste Lichtsignal (L₁) einen ersten Bruchteil eines divergenten Lichtstrahls vom Laser (900) darstellt und das zweite Lichtsignal (L₂) einen zweiten Bruchteil eines divergenten Lichtstrahls vom Laser (900) darstellt.

6. Wellenlängenstabilisiertes Lasermodul nach einem der vorangehenden Ansprüche,
**dadurch gekennzeichnet, dass**
der zweite Sensor (920) und das Filterelement (930) in Bezug auf den Laser (900) so angeordnet sind, dass ein Lichtstrahl (Iᵣ) vom Laser (900) senkrecht (N_{F}) zur Lichteinfalls- und -austrittsfläche des Filterelements (930) durch das Filterelement (930) zur lichtempfindlichen Oberfläche (82) des zweiten Sensors (920) läuft.

7. Wellenlängenstabilisiertes Lasermodul nach einem der vorangehenden Ansprüche,
**dadurch gekennzeichnet, dass**
das Filterelement (930) einen Filterneigungswinkel (α_{F}) zu einer Laserzentralachse (A_{L}) des Lasers (900) besitzt; und
die lichtempfindliche Oberfläche (S₂) des zweiten Sensors (920) einen Neigungswinkel (α₂) zur Laserzentralachse (A_{L}) besitzt, der im Wesentlichen gleich dem Filterneigungswinkel (α_{F}) ist.

8. Wellenlängenstabilisiertes Lasermodul nach einem der vorangehenden Ansprüche,
**dadurch gekennzeichnet, dass**
das Filterelement (930) einen Filterneigungswinkel (α_{F}) kleiner als oder gleich 7° besitzt.

9. Wellenlängenstabilisiertes Lasermodul nach einem der Ansprüche 6 bis 8,
**dadurch gekennzeichnet, dass**
der Halbleiterlaser (900) dafür geeignet ist, Licht mit einer Wellenlänge im Intervall von 1530 nm bis 1610 nm zu erzeugen; und
das Filterelement (930) mit der Lichteinfallsfläche in einem ersten Abstand (D₁) vom Laser (900) angeordnet ist, der kleiner als oder gleich 1600 µm ist.

10. Wellenlängenstabilisiertes Lasermodul nach einem der Ansprüche 6 bis 9,
**dadurch gekennzeichnet, dass**
die lichtempfindliche Oberfläche (S₂) des zweiten Sensors (920) einen im Wesentlichen rechteckigen Umriss mit Abmessungen (W₂) im Intervall von 50 µm bis 400 µm besitzt.

11. Wellenlängenstabilisiertes Lasermodul nach einem der Ansprüche 6 bis 10,
**dadurch gekennzeichnet, dass**
eine Zentralachse (A₂) des zweiten Sensors (920) bezüglich der Laserzentralachse (A_{L}) um einen Versetzungsabstand (X₂) verschoben ist und der Versetzungsabstand (X₂) kleiner als oder gleich 350 µm ist.

12. Wellenlängenstabilisiertes Lasermodul nach einem der Ansprüche 6 bis 11,
**dadurch gekennzeichnet, dass**
das Filterelement (930) eine Dicke (d) im Intervall von 300 µm bis 1000 µm besitzt; und mit der Lichtaustrittsfläche in einem zweiten Abstand (D₂) innerhalb von 1000 µm vom zweiten Sensor (920) angeordnet ist.

## Revendications

1. Module laser stabilisé en longueur d'onde comprenant :
un laser à semiconducteur (900) conçu pour produire un signal lumineux (L),
une première boucle de commande comprenant un premier capteur (910) conçu pour produire un premier signal électrique (I_{P}) en réponse à un premier signal lumineux (L₁) provenant du laser (900) et un module de surveillance d'alimentation (915) conçu pour recevoir le premier signal électrique (I_{P}) et, en réponse à celui-ci, produire un signal de commande d'alimentation (I_{bias}) vers le laser (900),
une deuxième boucle de commande comprenant un deuxième capteur (920) conçu pour produire un deuxième signal électrique (I_{W}) en réponse à un deuxième signal lumineux (L₂) provenant du laser, et un module de surveillance de longueur d'onde (925, 1225) conçu pour, sur la base du deuxième signal électrique (I_{W}), produire un signal de commande de longueur d'onde (I_{tec}) vers une interface de réglage de longueur d'onde du laser (900), le signal de commande de longueur d'onde (I_{tec}) et le signal de commande d'alimentation (I_{bias}) influençant tous deux les caractéristiques spectrales du signal lumineux (L),
un élément de filtre à transmission sélective en longueur d'onde à bande passante étroite (930) présentant une structure de Fabry-Pérot en tant que référence de longueur d'onde pour le laser (900) agencé pour constituer un élément intermédiaire exclusif entre le laser (900) et le deuxième capteur (920), de sorte que le deuxième signal lumineux (L₂) passe à travers l'élément de filtre (930) vers une surface de détection de lumière (S₂) du deuxième capteur (920),
où le premier capteur (910) est conçu de sorte que le premier signal lumineux (L₁) illumine directement une surface de détection de lumière du premier capteur (910) sans passer à travers l'élément de filtre (930),
**caractérisé par**
une unité de division (1240) conçue pour recevoir le premier signal électrique (I_{P}), recevoir le deuxième signal électrique (I_{W}) et, en réponse à ceux-ci, produire un signal de commande composite (R_{WP}) indicatif d'un rapport entre le premier signal électrique (I_{P}) et le deuxième signal électrique (I_{W}), le module de surveillance de longueur d'onde (1225) est conçu pour recevoir le signal de commande composite (R_{WP}) et, en réponse à cela, produire le signal de commande de longueur d'onde (I_{tec}) de sorte que la température du laser (900) sera commandée vers une valeur donnée par la valeur de consigne de longueur d'onde composite (I_{W-consigne}) indépendamment du niveau du premier signal électrique (I_{P}).

2. Module laser stabilisé en longueur d'onde selon la revendication 1,
**caractérisé en ce que**
la deuxième boucle de commande comprend une unité de refroidissement thermoélectrique (905) associée au laser (900) et l'unité de refroidissement thermoélectrique (905) est conçue pour recevoir le signal de commande de longueur d'onde (I_{tec}) et, en réponse à celui-ci, régler la température du laser (900).

3. Module laser stabilisé en longueur d'onde selon l'une quelconque des revendications 1 ou 2,
**caractérisé en ce que**
le premier signal lumineux (L₁) et le deuxième signal lumineux (L₂) sont prélevés par le biais d'une facette arrière du laser à semiconducteur (900).

4. Module laser stabilisé en longueur d'onde selon l'une quelconque des revendications précédentes,
**caractérisé en ce que**
le laser (900) est conçu pour produire les premier et deuxième signaux lumineux (L₁, L₂) sous la forme d'un flux de lumière non collimaté.

5. Module laser stabilisé en longueur d'onde selon la revendication 4,
**caractérisé en ce que**
le premier signal lumineux (L₁) constitue une première fraction d'un faisceau de lumière divergent provenant du laser (900) et le deuxième signal lumineux (L₂) constitue une deuxième fraction du faisceau de lumière divergent provenant du laser (900).

6. Module laser stabilisé en longueur d'onde selon l'une quelconque des revendications précédentes,
**caractérisé en ce que**
le deuxième capteur (920) et l'élément de filtre (930) sont agencés par rapport au laser (900) de sorte qu'un rayon de lumière (Iᵣ) provenant du laser (900) passe perpendiculairement (N_{F}) à la lumière incidente et sort des surfaces de l'élément de filtre (930) à travers l'élément de filtre (930) vers la surface de détection de lumière (82) du deuxième capteur (920).

7. Module laser stabilisé en longueur d'onde selon l'une quelconque des revendications précédentes,
**caractérisé en ce que**
l'élément de filtre (930) présente un angle d'inclinaison de filtre (α_{F}) vers un axe central de laser (A_{L}) du laser (900), et
la surface de détection de lumière (S₂) du deuxième capteur (920) présente un angle d'inclinaison (α₂) vers l'axe central de laser (A_{L}) qui est pratiquement égal à l'angle d'inclinaison de filtre (α_{F}).

8. Module laser stabilisé en longueur d'onde selon l'une quelconque des revendications précédentes,
**caractérisé en ce que**
l'élément de filtre (930) a un angle d'inclinaison de filtre (α_{F}) inférieur ou égal à 7 degrés.

9. Module laser stabilisé en longueur d'onde selon l'une quelconque des revendications 6 à 8,
**caractérisé en ce que**
le laser à semiconducteur (900) est conçu pour produire une lumière ayant une longueur d'onde dans l'intervalle de 1 530 nm à 1 610 nm, et
l'élément de filtre (930) est conçu avec la surface pour la lumière incidente à une première distance (D₁) du laser (900) qui est inférieure ou égale à 1 600 µm.

10. Module laser stabilisé en longueur d'onde selon l'une quelconque des revendications 6 à 9,
**caractérisé en ce que**
la surface de détection de lumière (S₂) du deuxième capteur (920) présente un contour pratiquement rectangulaire, avec des dimensions (W₂) dans l'intervalle de 50 µm à 400 µm.

11. Module laser stabilisé en longueur d'onde selon l'une quelconque des revendications 6 à 10,
**caractérisé en ce que**
un axe central (A₂) du deuxième capteur (920) est déplacé à une distance de décalage (X₂) par rapport à l'axe central du laser (A_{L}) et la distance de décalage (X₂) est inférieure ou égale à 350 µm.

12. Module laser stabilisé en longueur d'onde selon l'une quelconque des revendications 6 à 11,
**caractérisé en ce que**
l'élément de filtre (930) a une épaisseur (d) dans l'intervalle de 300 µm à 1 000 µm et est agencé avec la surface de sortie de lumière à une deuxième distance (D₂) qui est à moins de 1 000 µm du deuxième capteur (920).
